(19) Europäisches Patentamt

European Patent Office

Office européen des brevets

(11) **EP 1 707 970 A1**

(12) **DEMANDE DE BREVET EUROPEEN**

(43) Date de publication:
04.10.2006 Bulletin 2006/40

(51) Int Cl.:
*G01R 31/12* (2006.01)

(21) Numéro de dépôt: 06111743.8

(22) Date de dépôt: 27.03.2006

(84) Etats contractants désignés:
AT BE BG CH CY CZ DE DK EE ES FI FR GB GR
HU IE IS IT LI LT LU LV MC NL PL PT RO SE SI
SK TR
Etats d'extension désignés:
AL BA HR MK YU

(30) Priorité: 29.03.2005 FR 0550799

(71) Demandeur: AREVA T&D SA
92084 Paris La Defense (FR)

(72) Inventeurs:
• **Kuppuswamy, Raja**
**75018, PARIS (FR)**

• **Moore, Philip**
**Frome, BA11 2QU (GB)**
• **Portugues, Iliana**
**28016, MADRID (ES)**
• **Louise, Sébastien**
**Courbevoie 92400 (FR)**

(74) Mandataire: Poulin, Gérard
Société BREVATOME
3, rue du Docteur Lancereaux
75008 Paris (FR)

(54) **Procédé de detection de la position d'un front d'onde dans un signal reçu par un detecteur**

(57) Il s'agit d'un procédé de détection d'un front d'onde dans un signal reçu par un détecteur. Il consiste à :
- convertir le signal en un signal numérique,
- définir dans le signal numérique un groupe de travail de N échantillons successifs et éventuellement traiter les échantillons du groupe de travail,
- calculer à partir des échantillons du groupe de travail éventuellement traités, l'énergie du signal en terme de moyenne quadratique sur une fenêtre glissante, la fenêtre comportant un nombre optimal d'échantillons Lopt (Lopt inférieur à N),
- la position du front d'onde correspondant à celle de l'échantillon pour lequel l'énergie du signal dépasse pour la première fois un seuil qui est fonction de la valeur de l'énergie du signal antérieurement au front d'onde.

EP 1 707 970 A1

**Description**

**DOMAINE TECHNIQUE**

La présente invention concerne un procédé de détection de la position d'un front d'onde dans un signal reçu par un détecteur. Le signal peut être par exemple un signal acoustique ou un signal électromagnétique tel un signal radioélectrique.

La présente invention est utilisable en particulier dans les procédés de détection et de localisation de sources de décharges partielles dans un appareil électrique tel un transformateur de puissance. Les décharges partielles dans un transformateur sont associées à l'émission d'un signal acoustique (généralement ultrasonore). Le front d'onde dans le signal acoustique matérialise donc l'apparition de la décharge partielle. Par front d'onde on désigne la partie antérieure de l'onde située entre le point virtuel zéro et la valeur de crête.

Cette application aux appareils électriques n'est pas limitative, bien d'autres applications pourraient être concernées par exemple dans le domaine du sonar, ou la localisation d'une source vocale dans un espace.

**ÉTAT DE LA TECHNIQUE ANTÉRIEURE**

Actuellement, le temps de réponse d'un détecteur acoustique, c'est à dire le temps s'écoulant entre l'émission d'un front d'onde et sa détection par le détecteur est estimé par des techniques mathématiques de corrélation croisée soit dans le domaine temporel, soit dans le domaine fréquentiel. Les documents [1] à [6] dont les références se trouvent en fin de description donnent des explications à leur sujet. Ces techniques ne conviennent pas lorsque la source acoustique se trouve dans un milieu bruyant, dans lequel des réverbérations du signal peuvent se produire et dans lequel le signal acoustique peut se propager jusqu'au détecteur en employant plusieurs trajets. C'est le cas des transformateurs de puissance puisque les enroulements se trouvent dans une enceinte emplie d'un fluide diélectrique acoustiquement conducteur tel de l'huile et qu'il peut se produire des réflexions sur les parois de l'enceinte.

Dans le domaine de la localisation de source de décharge partielle, il est connu notamment du document [7] dont les références se trouvent en fin de description, de détecter électriquement l'instant d'apparition d'une décharge partielle et d'acquérir visuellement l'instant d'arrivée du front d'onde associé, au niveau d'un détecteur fixé sur la paroi extérieure de l'enceinte. On se base sur une propagation linéaire du signal acoustique et sur une vitesse connue fonction du milieu diélectrique. On peut calculer la distance entre le détecteur et la source de décharge partielle. En déplaçant le détecteur en plusieurs lieux de l'enceinte, la position de la source de décharge partielle peut être déduite par triangulation.

Dans une seconde méthode, on utilise simultanément au moins une paire de détecteurs acoustiques et on calcule la différence de temps mis par une onde acoustique pour parcourir la distance entre la source de décharge partielle et chacun des détecteurs de la paire. Les instants d'arrivée du front de l'onde au niveau de chacun des détecteurs acoustiques sont déterminés visuellement. En connaissant les positions des détecteurs acoustiques, on définit un premier hyperboloïde sur lequel se situe la source de décharge partielle. En utilisant une autre paire de détecteurs acoustiques ou en déplaçant la première paire de détecteurs, on définit de la même façon un second hyperboloïde, la source de décharge partielle se situant à l'intersection entre les deux hyperboloïdes. D'autres méthodes sont encore connues qui dérivent des méthodes précédentes. Dans toutes ces méthodes, on ne fait qu'une estimation visuelle de l'instant d'arrivée du front d'onde du signal au niveau de chaque détecteur, c'est-à-dire de la position du front d'onde dans le signal reçu par le détecteur. Dans la seconde méthode de plus, on n'est jamais sûr que les signaux détectés par les deux détecteurs proviennent de la même source de décharge partielle. En conclusion, il en résulte un manque de précision de la localisation de la source de décharge partielle et la détection de la décharge partielle ne se fait pas en temps réel puisque les calculs ne peuvent être effectués qu'après avoir repéré visuellement l'instant d'arrivée du front d'onde du signal représentatif de la décharge partielle au niveau du ou des détecteurs mis en jeu.

**EXPOSÉ DE L'INVENTION**

La présente invention a justement comme but de proposer un procédé automatique de détection de la position d'un front d'onde dans un signal reçu par un détecteur. Ce procédé permet de se passer de la détection visuelle du front d'onde et donne des résultats bien plus précis.

Pour y parvenir, la présente invention propose d'acquérir le signal par le détecteur,

de le convertir en un signal numérique

de définir dans le signal numérique un groupe de travail de N échantillons successifs et d'éventuellement traiter les échantillons du groupe de travail,

de calculer à partir des échantillons du groupe de travail éventuellement traités, l'énergie du signal en terme de moyenne quadratique sur une fenêtre glissante, la fenêtre comportant un nombre optimal d'échantillons $L_{opt}$ ($L_{opt}$ inférieur à N),

la position du front d'onde correspondant à celle de l'échantillon pour lequel l'énergie du signal dépasse pour la première fois un seuil D qui est fonction de la valeur de l'énergie du signal antérieurement au front d'onde.

Le nombre optimal d'échantillons Lopt de la fenêtre est déterminé en choisissant un nombre arbitraire d'échantillons L',

en calculant l'énergie du signal partielle en terme de moyenne quadratique dans une plage de P premiers échantillons du groupe de travail, la fenêtre glissante comportant le dit nombre arbitraire L' d'échantillons,

en calculant la moyenne de l'énergie du signal partielle en terme de moyenne quadratique dans la plage des P premiers échantillons,

en calculant l'écart-type de l'énergie du signal partielle en terme de moyenne quadratique dans la plage des P premiers échantillons,

en calculant le rapport de la moyenne sur l'écart-type, le nombre optimal d'échantillons Lopt de la fenêtre glissante correspondant au minimum de ce rapport ou à défaut au maximum de ce rapport.

Le seuil D est un multiple r de l'écart-type auquel on ajoute la moyenne dans la plage des P premiers échantillons.

La définition du groupe de travail consiste à ôter dans un groupe d'échantillons obtenu par la conversion analogique numérique un sous-groupe d'échantillons successifs considéré comme saturé.

Un premier échantillon x(k) du sous-groupe est considéré comme saturé si cet échantillon x(k) et les trois qui le suivent x(k+1), x(k+2), x(k+3) vérifient les relations suivantes

$$\left| x(k) - x(k+1) \right| > \varepsilon$$

et

$$\left| x(k+1) - x(k+2) \right| > \varepsilon$$

et

$$\left| x(k+2) - x(k+3) \right| > \varepsilon$$

et

$$\left| x(k) \right| > \theta$$

avec $\varepsilon$ premier plancher et $\theta$ second plancher, le sous-groupe comprenant tous les échantillons du groupe d'échantillons obtenu par la conversion analogique, qui suivent le premier échantillon considéré comme saturé.

On peut choisir par exemple $\varepsilon = 10^{-6}$V et $\theta = 1$V.

Le traitement peut consister à filtrer les échantillons de manière à éliminer d'une part une composante continue et d'autre part à amplifier des échantillons dans les plus hautes fréquences.

Ce filtrage peut se faire par dérivation.

Il est possible de fixer le nombre P d'échantillons dans la plage à une fraction u de la position jc d'un premier échantillon pour lequel l'énergie du signal sous forme de moyenne quadratique est supérieure à un multiple q du maximum de l'énergie du signal sous forme quadratique sur une plage d'un nombre approché P' de premiers échantillons du signal, q et P' étant choisis arbitrairement.

La fraction u peut être choisie comme étant égale à 0,9.

La présente invention concerne également un procédé de détermination du temps de réponse d'au moins un détecteur exposé à un signal comportant un front d'onde. Il consiste à détecter le front d'onde du signal reçu par le détecteur selon le procédé précédent et à comparer la position détectée au niveau du détecteur à celle détectée par le même procédé au niveau d'un autre détecteur de référence.

La présente invention concerne également un procédé de détection et de localisation d'une source de décharge partielle dans un appareil électrique placé dans une enceinte contenant un fluide acoustiquement conducteur. Il consiste

- à disposer plusieurs détecteurs acoustiques contre l'extérieur de l'enceinte et à acquérir leurs positions,
- à former un ou plusieurs groupes de détecteurs, ces groupes étant des triplets ou des quadruplets,
- à détecter pour chacun des détecteurs de certains groupes au moins, la position d'un front d'une onde acoustique émise par la source de décharge partielle par le procédé ainsi défini, cette position étant représentative de l'instant de réception de l'onde acoustique émise par la source de décharge partielle, par chacun des détecteurs ;
- à calculer, pour certains groupes au moins, la position de la source de décharge partielle vue de ces groupes à partir de la position des détecteurs acoustiques et de l'instant de réception de l'onde acoustique émise par la source de décharge partielle par chacun des détecteurs.

Le calcul de la position de la source de décharge partielle vue d'un groupe formé d'un triplet peut se faire par triangulation en résolvant le système d'équations suivant :

$$(x-xi)^2 + (y-yi)^2 + (z-zi)^2 - v^2(ti-t0)^2 = 0$$

$$(x-xj)^2 + (y-yj)^2 + (z-zj)^2 - v^2(tj-t0)^2 = 0$$

$$(x-xk)^2 + (y-yk)^2 + (z-zk)^2 - v^2(tk-t0)^2 = 0$$

dans lequel (x, y, z) représentent la position de la source de décharge partielle, (xi, yi, zi), (xj, yj, zj), (xk, yk, zk) la position des détecteurs acoustiques du triplet, t0 un instant d'émission d'une décharge partielle générée par la source de décharge partielle et ti, tj, tk les instants de réception de l'onde acoustique émise par la décharge partielle par chacun des détecteurs acoustiques du triplet, v la vitesse de l'onde acoustique dans le fluide.

L'instant d'émission de la décharge partielle peut être mesuré par des moyens électriques tels un détecteur électrique de type antenne qui coopère avec l'enceinte.

Le calcul de la position de la source de décharge partielle vue d'un groupe formé d'un quadruplet peut se faire par triangulation en résolvant le système d'équations suivant :

$$\sqrt{(x-xj)^2+(y-yj)^2+(z-zj)^2} -$$
$$\sqrt{(x-xi)^2+(y-yi)^2+(z-zi)^2} -v(tj-ti) = 0$$

$$\sqrt{(x-xk)^2+(y-yk)^2+(z-zk)^2} -$$
$$\sqrt{(x-xi)^2+(y-yi)^2+(z-zi)^2} -v(tk-ti) = 0$$

$$\sqrt{(x-xl)^2+(y-yl)^2+(z-zl)^2} -$$
$$\sqrt{(x-xi)^2+(y-yi)^2+(z-zi)^2} -v(tl-ti) = 0$$

dans lequel (x, y, z) représentent la position de la source de décharge partielle, (xi, yi, zi), (xj, yj, zj), (xk, yk, zk), (xl, yl, zl) la position des quatre détecteurs acoustiques du quadruplet, ti, tj, tk, tl les instants de réception de l'onde acoustique émise par la décharge partielle par chacun des détecteurs acoustiques du quadruplet, v est la vitesse de l'onde acoustique dans le fluide.

Il est préférable de vérifier que la position trouvée pour la source de décharge partielle vue d'un groupe se trouve à l'intérieur de l'enceinte, sinon on élimine ladite position.

Pour améliorer la précision de la localisation, on peut effectuer une première vérification avant le calcul pour s'assurer que chaque groupe est exempt de triangle, à sommets matérialisés par trois détecteurs acoustiques, dont au moins un angle est hors d'une plage d'angle prédéterminée, dans le cas contraire le groupe ne participe pas au calcul.

Pour améliorer la précision de la localisation, il est préférable d'effectuer une seconde vérification après le calcul pour s'assurer que chaque groupe non éliminé après la première vérification est exempt de triangle matérialisé par deux des détecteurs du groupe et par la position de la source de décharge partielle vue du groupe, dont au moins un angle est hors de la plage prédéterminée, dans le cas contraire le groupe est éliminé.

La plage d'angles peut s'étendre entre 30° et 151° bornes incluses.

Lorsqu'on obtient plusieurs positions à partir de plusieurs groupes non éliminés et que ces positions se trouvent à l'intérieur de l'enceinte, on calcule une moyenne des positions de la source de décharge partielle calculées pour chacun des groupes et non éliminées.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

Les figures 1A, 1B montrent l'allure de signaux électriques délivrés par deux détecteurs placés au sein d'une même enceinte d'un appareil électrique, après une conversion analogique-numérique, la figure 1C montre dans un contexte différent, un signal délivré par un autre détecteur de type différent de ceux utilisés précédemment, comportant une plage saturée ;

Les figures 2A, 2B, 2C montrent respectivement des groupes d'échantillons de travail des signaux des figures 1A, 1B, 1C après traitement ;

La figure 3 montre l'allure de la réponse en fréquence d'un signal numérisé après traitement ;

Les figures 4A, 4B, montrent les énergies des signaux des figures 2A, 2B, en terme de moyenne quadratique ainsi que la position du front d'onde ;

Les figures 5A, 5B, montrent les rapports de l'écart-type sur la moyenne des énergies partielles des signaux des figures 2A, 2B ;

Les figures 6A, 6B, 6C, 6D montrent, lors d'un second passage, respectivement l'énergie du signal des figure 2A, 2B en terme de moyenne quadratique et le rapport de l'écart-type sur la moyenne de l'énergie partielle du signal des figures 2A, 2B;

La figure 7 illustre la variation de la position du front d'onde en fonction du seuil D obtenue à partir des signaux de la figure 1A ;

Les figures 8A à 8F illustrent l'allure d'un signal délivré par 5 détecteurs Ch2 à Ch6 ainsi que les positions du front d'onde déterminées par le procédé de l'invention et par observation visuelle ;

La figure 9 montre un transformateur équipé d'un appareillage permettant de détecter et de localiser une source de décharge partielle par le procédé de l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

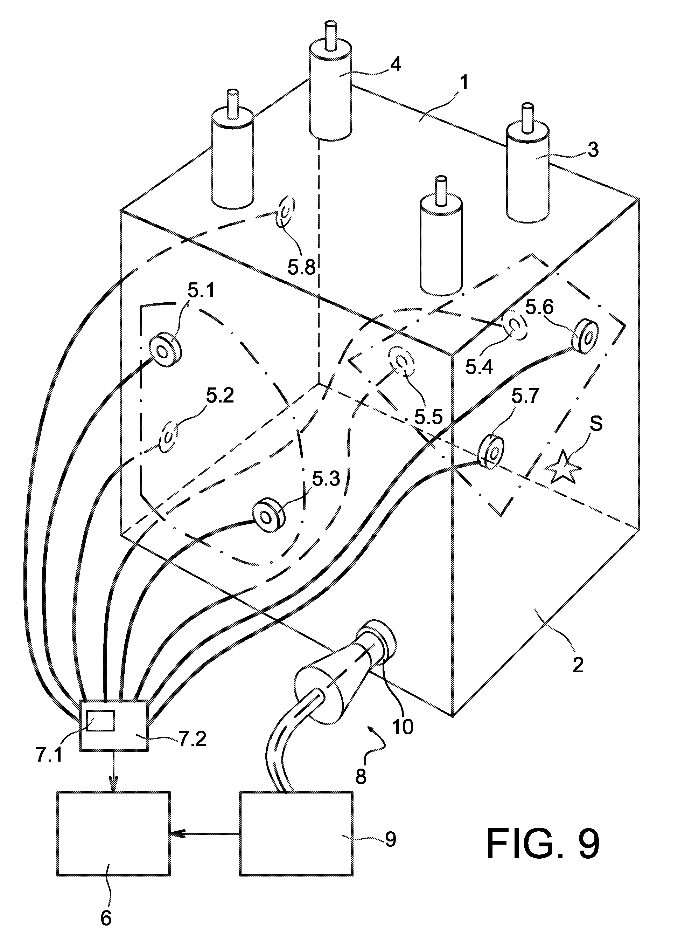

On va maintenant s'attacher à décrire le procédé de détection de la position d'un front d'onde F dans un signal acquis par un détecteur. On suppose dans l'exemple décrit que ce signal est acoustique et qu'il provient de l'intérieur de l'enceinte d'un appareil électrique, le front d'onde F traduisant l'apparition d'une décharge partielle au niveau d'une source de décharge partielle. Cet appareil électrique, par exemple un transformateur de puissance, est placé dans une enceinte contenant un fluide conducteur. Le détecteur serait placé contre l'extérieur de l'enceinte. On peut se référer à la figure 9 qui montre schématiquement un tel appareil équipé d'un appareillage permettant la détection et la localisation de la source de décharge partielle S.

Dans d'autres applications, le signal serait un signal vocal et le détecteur un microphone si l'on désire détecter la prise de parole d'une personne dans une pièce par exemple. En fait les problèmes d'estimation de temps de propagation existent dans de nombreuses applications par exemple la détermination de la portée et du gisement d'un radar, la poursuite et la localisation de sources radioélectriques, la mesure de températures d'alliages fondus.

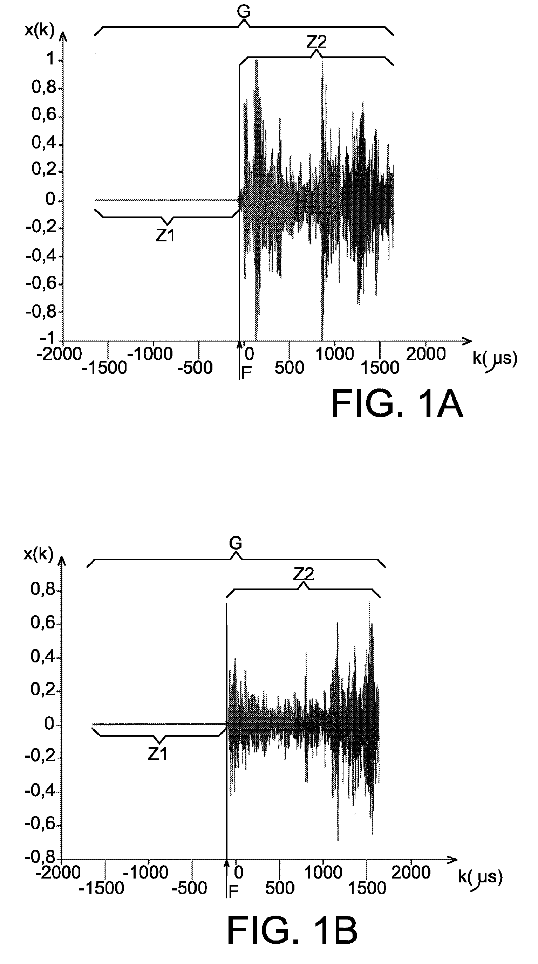

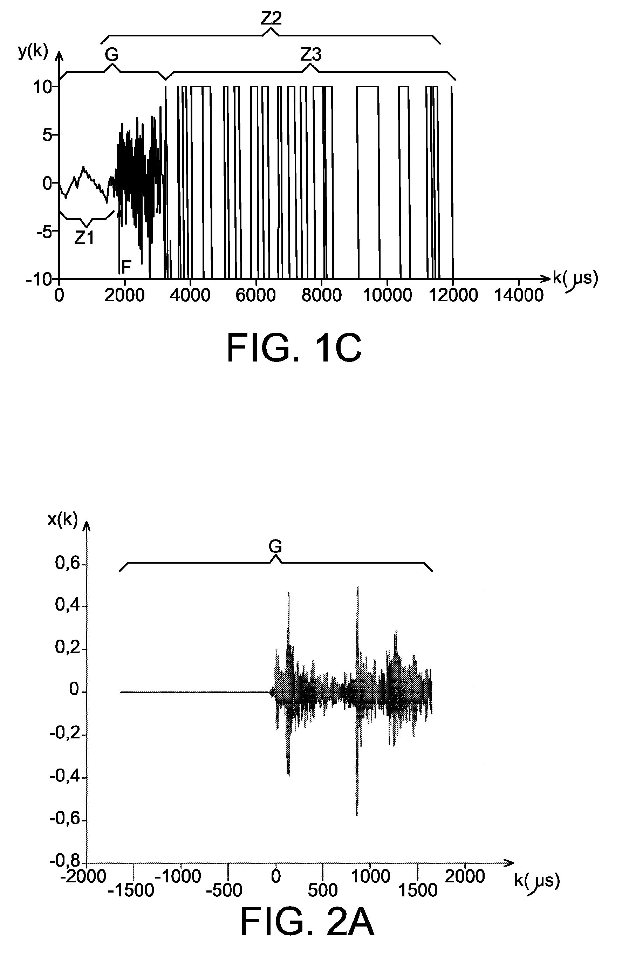

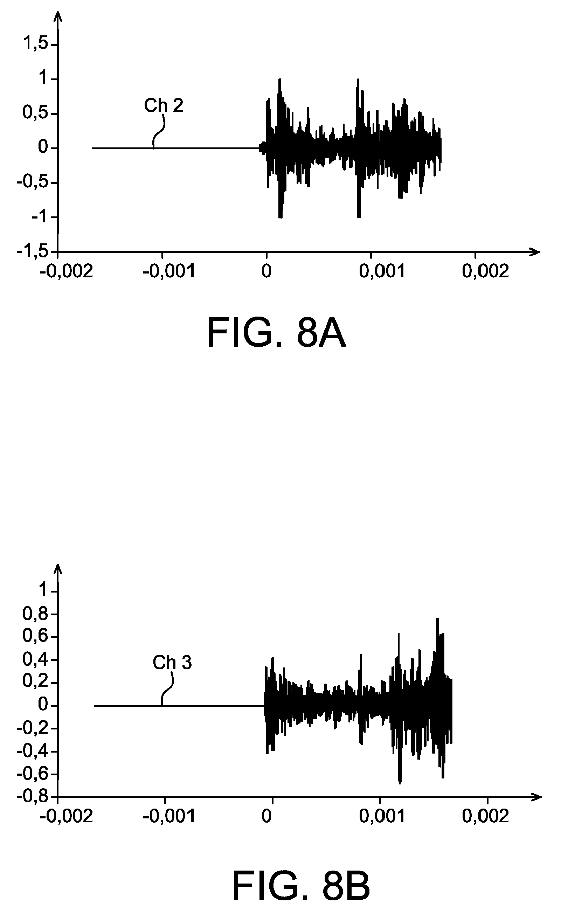

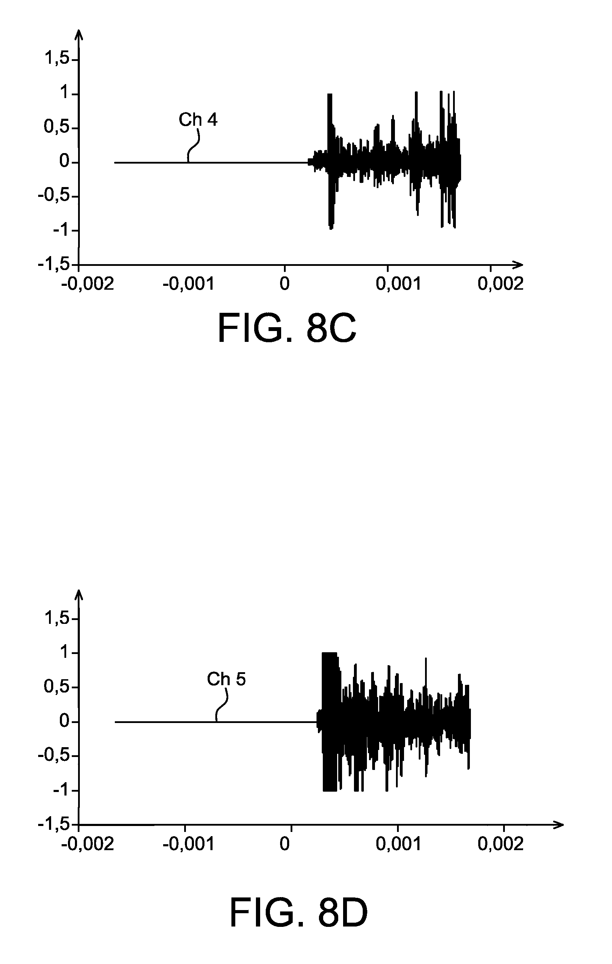

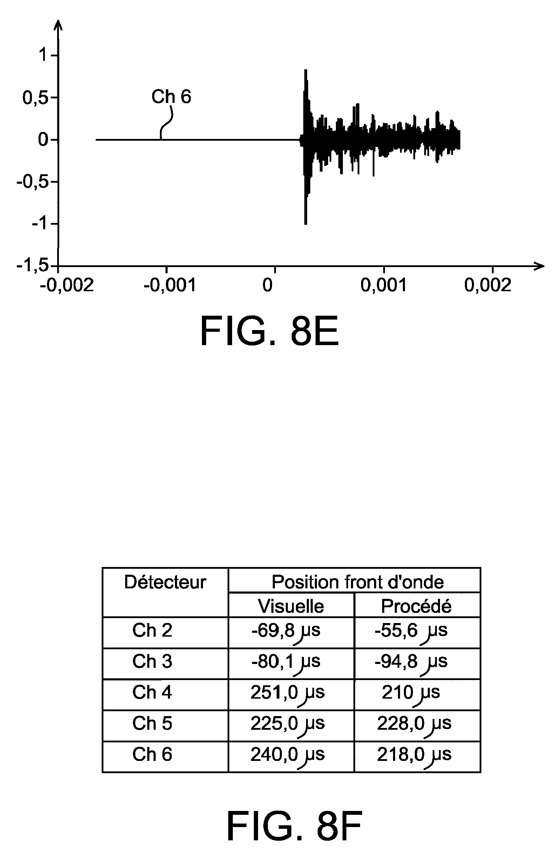

On se réfère aux figures 1A, 1B, 1C qui montrent l'allure de signaux électriques délivrés par des détecteurs après une conversion analogique-numérique. Les signaux des figures 1A, 1B proviennent de deux détecteurs de même type placés à des endroits différents et utilisés au cours de la même expérience. L'origine du signal qu'ils détectent est la même. Signalons que ces deux détecteurs correspondent respectivement aux détecteurs notés ch2 et ch3 dont les mesures sont données en figure 8F. Les signaux de la figure 1C proviennent d'un détecteur d'un autre type fonctionnant dans un autre contexte mais également placé dans l'enceinte d'un appareil électrique. Ces signaux sont représentatifs du signal acoustique qu'ils ont reçu de l'intérieur de l'enceinte. Les signaux de la figure 1C ne sont pas enregistrés pendant la même séquence de test que ceux des figures 1A, 1B. Ces signaux ont une amplitude sensiblement constante dans une première plage z1 antérieure à l'arrivée du front d'onde F dont on veut détecter la position. L'amplitude du signal dès l'arrivée du front d'onde F et postérieurement à cette arrivée est très supérieure à celle du signal dans la première plage z1. On distingue ainsi une seconde plage z2 en aval du front d'onde.

Le signal numérique est de la forme x(k) et k représente les échantillons successifs du signal numérique. Le nombre H d'échantillons successifs et donc leur position au sein de cette succession sont représentatifs du temps. On suppose que le nombre d'échantillons est égal à H ainsi $k \subset \{1, H\}$.

On va définir pour ce signal x(k) un groupe d'échantillons de travail G. Ce groupe d'échantillons de travail G s'étend à la fois sur la plage z1 et sur la plage z2. Ce groupe d'échantillons de travail G peut comporter les H échantillons successifs mais bien souvent, il sera préférable de réduire le nombre d'échantillons pour former le groupe d'échantillons de travail G car une partie des échantillons risque de fausser le calcul visant à détecter la position du front d'onde.

Cela peut être le cas si le signal numérique x(k) présente une partie saturée. Cette saturation peut provenir de la conversion analogique numérique et peut perturber la détection de la position du front d'onde F. On suppose que sur la figure 1C le signal x(k) comporte une partie saturée z3 et que sur les figures 1A, 1B. il n'en comporte pas.

Cette vérification peut se faire en analysant tous les échantillons successivement depuis le premier, de manière à repérer un premier échantillon considéré comme saturé. On ôtera alors des H échantillons, la partie saturée z3 qui est alors formée du premier échantillon repéré comme étant saturé et de tous ceux qui le suivent.

Pour repérer le premier échantillon considéré comme saturé, on vérifie si un quadruplet d'échantillons successifs x(k), x(k+1), x(k+2), x(k+3) vérifie les relations ci-dessous :

$$\left| x(k) - x(k+1) \right| > \varepsilon$$

et

$$\left| x(k+1) - x(k+2) \right| > \varepsilon$$

et

$$\left| x(k+2) - x(k+3) \right| > \varepsilon$$

et

$$\left| x(k) \right| > \theta$$

avec $\varepsilon$ premier plancher et $\theta$ second plancher, le premier échantillon x(k) considéré comme saturé étant le premier échantillon du quadruplet x(k). La partie de signal z3 comprenant tous les échantillons du groupe qui suivent le premier échantillon x(k) considéré comme saturé est alors éliminée. On peut choisir par exemple $\varepsilon = 10^{-6}$Volt et $\theta = 1$ Volt.

Il est préférable de traiter le signal numérique x(k) exempt de saturation en le filtrant de manière à éliminer toute composante continue et à accentuer l'amplitude d'échantillons dans les plus hautes fréquences. Ce filtrage peut se faire par dérivation.

Le signal x(k) est traité en soustrayant d'un échantillon celui qui le précède. Il devient :

$$y(k) = x(k) - x(k-1)$$

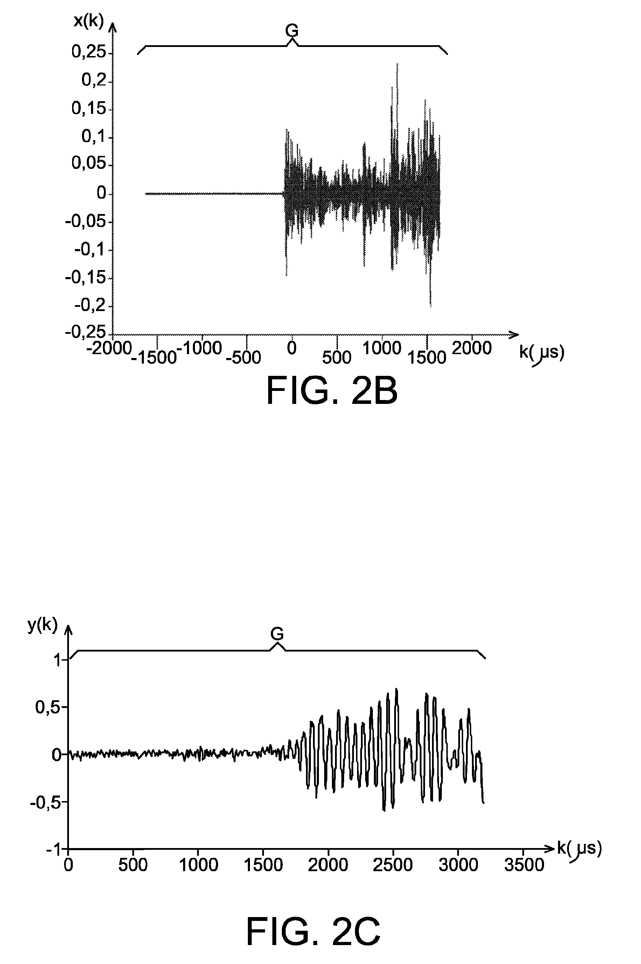

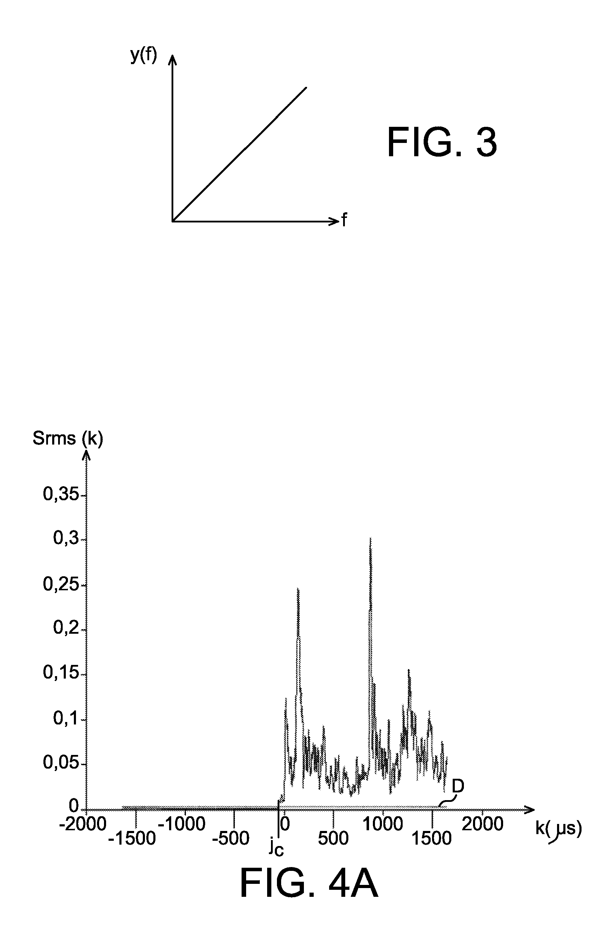

La réponse en fréquence de ce type de signal numérique filtré y(k) est représentée sur la figure 3. Cette réponse en fréquence est linéaire et passe par l'origine à fréquence nulle. Cette linéarité est avantageuse dans la détection du front d'onde, dans une application de localisation de décharge partielle dans un appareil électrique de type transformateur, car des ondes ayant des fronts raides contiennent relativement beaucoup de hautes fréquences, et ces hautes fréquences sont atténuées par l'environnement de propagation non idéal autour du transformateur, c'est-à-dire le milieu diélectrique. La modification du profil des fréquences rend ce traitement bénéfique. Les figures 2A, 2B, 2C montrent respectivement l'allure des signaux des figures 1A, 1B, 1C après filtrage et élimination des échantillons saturés.

Les N échantillons ainsi obtenus forment le groupe d'échantillons de travail G avec G= z1+z2-z3. On va maintenant calculer à partir des échantillons du groupe de travail G, l'énergie du signal en terme de moyenne quadratique Srms(k) sur une fenêtre glissante ayant une largeur optimale de Lopt échantillons. Cette énergie du signal Srms(k) est un signal unipolaire. Par la suite l'énergie du signal en terme de moyenne quadratique sera appelée tout simplement énergie du signal Srms(k).

L'énergie du signal Srms(k) se calcule de la manière suivante .

$$Srms(k) = \sqrt{\sum_{i=0}^{Lopt-1} \frac{y(k+i)^2}{Lopt}}$$

L'utilisation de la fenêtre glissante avec un nombre d'échantillons optimal Lopt a un effet significatif de filtrage sur le signal numérique y(k). Si le nombre d'échantillons Lopt est choisi correctement, c'est-à-dire s'il est optimal, le calcul de l'énergie du signal Srms(k) a pour conséquence de lisser le signal sur la plage z1 en amont du front d'onde F. On peut alors déterminer avec précision la position j du front d'onde F en appliquant un seuil D à l'énergie du signal Srms(k). Cette comparaison par rapport au seuil D est possible puisque l'énergie du signal Srms(k) est un signal unipolaire. Plus particulièrement, la position j du front d'onde F correspond à celle du premier échantillon y(j) dont l'amplitude dépasse le seuil D. j traduit le rang de l'échantillon, c'est à dire sa position dans la succession d'échantillons et cette position est représentative d'un instant et s'exprime en unité de temps. Le seuil D dépend de la valeur du signal y(k) en amont du front d'onde F.

On cherche donc à trouver dans la succession d'échantillons y(k), le premier j qui vérifie la relation :

$$Srms(j) > D \hspace{4cm} (1)$$

avec D= $r\sigma+\mu$. r est un nombre entier ou non, choisi par l'utilisateur, et $\mu$ représente la moyenne de l'énergie du signal Srms(k) et $\sigma$ l'écart-type de l'énergie du signal Srms(k). Le choix de r se fait par expérience.

On rappelle que la moyenne $\mu$ s'exprime par :

$$\mu = \frac{1}{N-Lopt} \sum_{i=1}^{N-Lopt} Smrs(i)$$

et que l'écart-type par :

$$\sigma = \sqrt{\frac{1}{N-Lopt-1} \sum_{i=1}^{N-Lopt} (Srms(i)-\mu)^2}$$

La moyenne $\mu$ et l'écart-type $\sigma$ sont calculés sur les N échantillons du groupe d'échantillons de travail G.

On va voir maintenant comment déterminer la valeur de la largeur optimale Lopt de la fenêtre glissante. On commence par choisir une largeur approchée L', typiquement L' est compris entre 5 et 100. A partir de cette largeur approchée L', on calcule une énergie du signal partielle Srms(k)' sur une plage de P échantillons du signal, cette plage correspond aux P premiers échantillons du signal y(k) situés en amont du front d'onde F.

On verra par la suite comment fixer avec précision le nombre d'échantillons P c'est à dire la largeur de la plage.

$$Srms(k)' = \sqrt{\sum_{i=1}^{P-L'} \frac{y(k+i)^2}{P-L'}}$$

On obtient P-L' valeurs de l'énergie du signal partielle Srms (k)'. On peut alors calculer la moyenne $\mu$' et l'écart-type $\sigma$' de l'énergie de signal partielle Srms(k)' dans cette plage de P échantillons en utilisant la fenêtre glissante de largeur approchée L'. Cette moyenne $\mu$' et cet écart-type $\sigma$' s'expriment par :

$$\mu' = \frac{1}{P-L'} \sum_{i=1}^{P-L'} Srms(i)'$$

et

$$\sigma' = \sqrt{\frac{1}{P-L'-1} \sum_{i=1}^{P-L'} (Srms(i)' - \mu')^2} \ .$$

Il est alors possible de calculer le rapport $\sigma$' / $\mu$' . Ce rapport donne une mesure du lissage de l'énergie de signal partielle Srms(k)'.

La valeur optimale Lopt de la largeur de la fenêtre est celle qui correspond au minimum du rapport $\sigma$'/ $\mu$'. Si la forme du signal y(k) est telle que le rapport $\sigma$'/ $\mu$' n'a pas de minimum, la valeur optimale Lopt de la largeur de la fenêtre est celle qui correspond au maximum du rapport $\sigma$'/$\mu$'. Généralement pour des applications de localisation de source de décharge partielle dans un appareil électrique tel un transformateur on obtient Lopt compris entre 5 et 100.

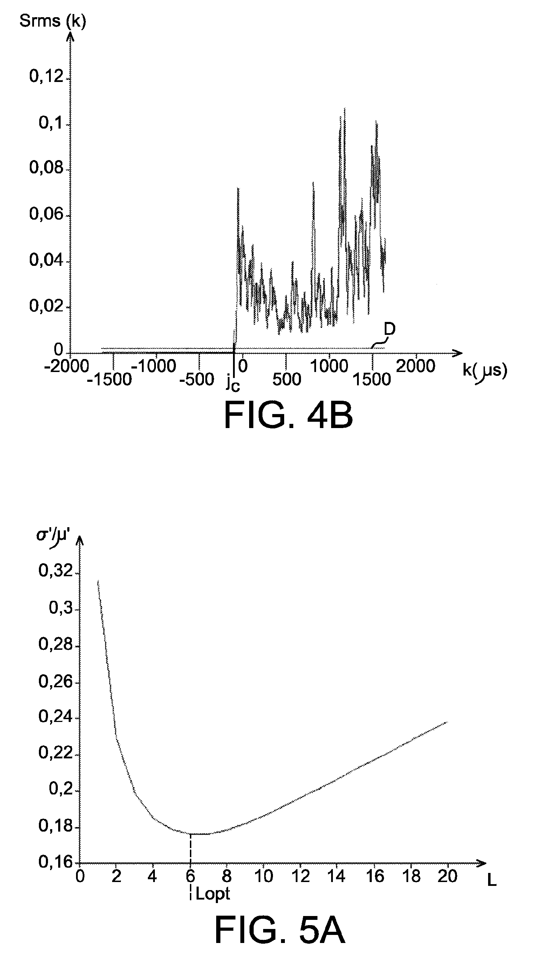

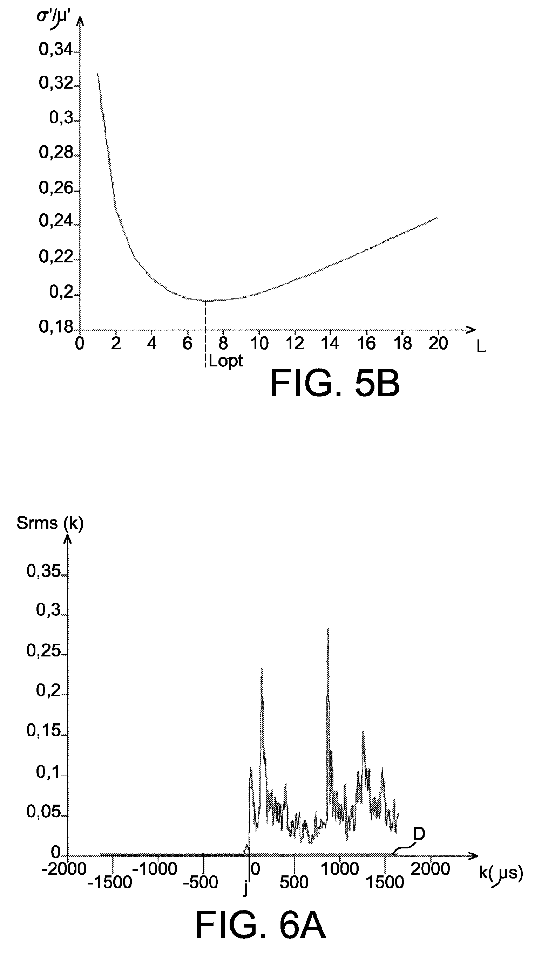

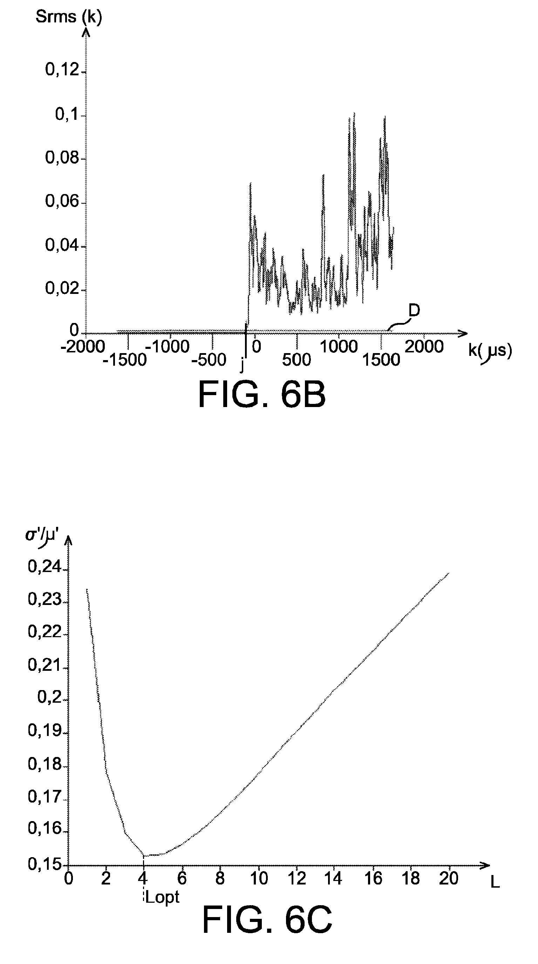

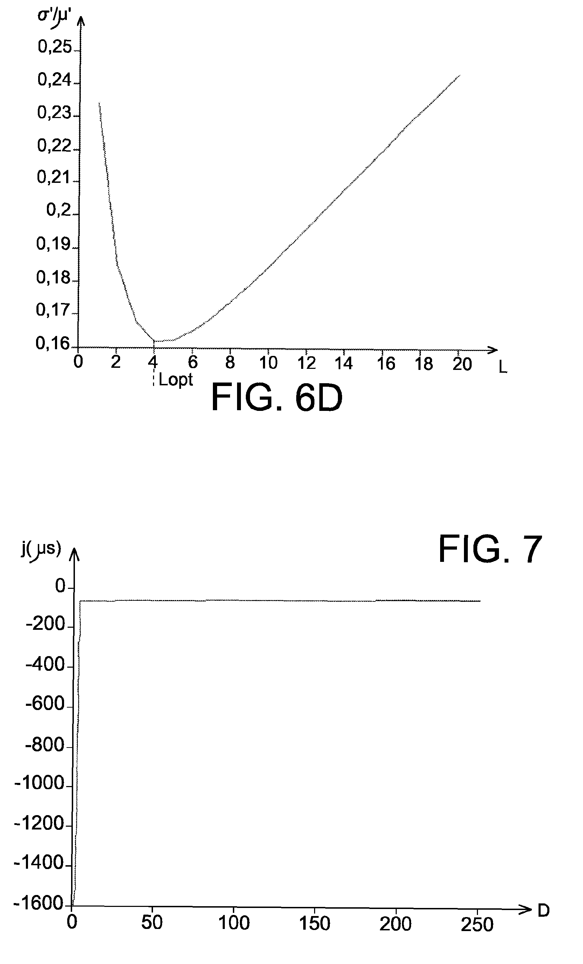

Sur la figure 5A, Lopt vaut 6, sur la figure 5B, Lopt vaut 7, sur la figure 6C, Lopt vaut 4 et sur la figure 6D, Lopt vaut 4.

C'est avec cette valeur optimale Lopt de la largeur de la fenêtre que l'on va rechercher la position j du premier échantillon qui dépasse le seuil D en appliquant la formule (1).

On va voir maintenant comment déterminer avec précision la largeur optimale P de la plage des premiers échantillons située en amont du front d'onde F.

Le lissage de l'énergie du signal partielle Srms(k)' qui est limitée aux P premières valeurs du signal y(k) peut causer la détection d'une position peu précise et même erronée du front d'onde F si les caractéristique du signal y(k) varient considérablement entre l'échantillon de rang P et le front d'onde F. C'est pour éviter cela qu'il il est préférable d'affiner la détection, en procédant à la détection d'une position approchée jc pour le front d'onde F et en fixant la largeur optimale P de la plage des premiers échantillons à une fraction u, inférieure à un, de la position approchée jc.

La position approchée jc pour le front d'onde F est la première position pour laquelle **$Srms(jc) > q|\max Srms(k)'|$** avec k inclus dans l'ensemble {1, P'}, q est un nombre inférieur à un, et P' est une largeur approchée de la plage des premiers échantillons, q et P' sont fixés par l'utilisateur par expérience. q est typiquement compris entre 2 et 10 et P' entre 200 et 5000. Dans les exemples décrits des figures 4A, 4B q vaut 7 et P' 2000.

On suppose que les figures 4A, 4B montrent cette position approchée jc du front d'onde F, l'énergie du signal Srms (k) étant représentée lors d'une première recherche de cette position (appelée premier passage). A partir de la position approchée jc du front d'onde F, on peut calculer la largeur optimale P de la plage des premières valeurs du signal telle que P=u.jc. Une valeur avantageuse de u est de choisir u = 0,9. Il suffit de calculer en appliquant la formule (1) la position j du front d'onde F sur la plage optimale de P échantillons en recalculant bien sûr la largeur optimale Lopt de la fenêtre.

On suppose que les figures 6C, 6D illustrent le calcul de la largeur optimale Lopt de la fenêtre lors d'un second passage et que les figures 6A, 6B illustrent le calcul de la position du front d'onde j également lors du second passage. La largeur optimale Lopt est égale à 4 dans ces deux cas.

L'énergie du signal en amont du front d'onde a été mieux lissée et la détermination de la position j du front d'onde F est plus précise que lors du premier passage.

La figure 7 montre la variation de la position j du front d'onde F en fonction du seuil D. Cette variation présente une partie coudée (appelée knee level en anglais). Le seuil D employé (repéré par la droite verticale) se trouve près de cette partie coudée ce qui signifie que le seuil est bien choisi.

On va maintenant en se référant aux figures 8A à 8E illustrer l'allure d'un même signal acoustique avec un front d'onde reçu par cinq détecteurs différents notés Ch2 à Ch6. La figure 8F est un tableau qui donne pour chacun des détecteurs Ch2 à Ch6 la position du front d'onde détectée visuellement ou bien à l'aide du procédé de l'invention. Les valeurs obtenues par le calcul dépendent bien sûr du choix du seuil D et ce choix dépend de l'expérience de l'utilisateur. On s'aperçoit qu'il existe une bonne corrélation entre les positions détectées visuellement et obtenues par le procédé.

On peut utiliser la position j du front d'onde F ainsi déterminée qui traduit l'instant de réception du front d'onde F par le détecteur pour déterminer le temps écoulé entre l'émission du front d'onde et sa réception par le détecteur, c'est à dire le retard entre l'émission du front d'onde et sa réception par le détecteur (time delay ou time lag en anglais). Ce temps correspond au temps de réponse du détecteur. Il faut alors disposer dudit détecteur et d'un détecteur de référence. Pour chacun d'entre eux on déterminer la position du front d'onde d'un même signal qu'ils reçoivent. L'un d'entre eux est considéré comme détecteur de référence. Il suffit alors de faire une simple soustraction entre les deux positions détectées, cette différence est représentative du temps écoulé entre l'émission du front d'onde et la réception par le détecteur. En pratique chacun des détecteurs sera utilisé à son tour en tant que détecteur de référence.

La présente invention concerne également un procédé de localisation d'une source de décharge partielle S dans un appareil électrique 2 tel un transformateur de puissance par exemple. On se réfère à la figure 9. Cette source de décharge partielle S émet un signal acoustique débutant par un front d'onde qui peut être détecté par le procédé qui vient d'être décrit.

Un procédé particulièrement simple pour détecter la position d'une source de décharge partielle S dans l'appareil électrique 1 placé dans une enceinte 2 contenant un fluide acoustiquement conducteur peut consister à positionner au moins quatre détecteurs 5.1, 5.2, 5.3, 5.4, contre l'extérieur de l'enceinte 2 de l'appareil électrique 1.

Les détecteurs acoustiques 5.1, 5.2, 5.3, 5.4 sont connectés électriquement d'une part à des moyens d'alimentation en énergie 7.1 et d'autre part à des moyens d'acquisition et de traitement 7.2 des signaux délivrés par eux.

Ces moyens de traitement 7.2 de signaux incluent des moyens de filtrage et de conversion analogique numérique. La référence 6 illustre des moyens de calcul tel un ordinateur ou un calculateur. Ils reçoivent les signaux délivrés par les détecteurs après traitement. Les références 3 et 4 illustrent respectivement des traversées à haute tension et à basse tension qui traversent l'enceinte 1 du transformateur.

On acquiert les coordonnées de ces quatre détecteurs, elles s'expriment par (xi, yi, zi) pour le détecteur 5.1, (xj, yj, zj) pour le détecteur 5.2 et (xk, yk, zk) pour le détecteur 5.3, (xl, yl, zl) pour le détecteur 5.4 dans un repère orthonormé lié par exemple à l'enceinte 2. Il peut s'agir de l'un des coins de l'enceinte 2 et de trois de ses arrêtes qui matérialisent ce coin si l'enceinte 2 est parallélépipédique. Les coordonnées de la source S de décharge partielle vue du quadruplet de détecteurs sont notées x, y, z, ce sont des inconnues.

On résout ensuite par optimisation le système d'équations à trois inconnues x, y, z suivant :

$$\sqrt{(x-xj)^2 + (y-yj)^2 + (z-zj)^2} -$$

$$\sqrt{(x-xi)^2 + (y-yi)^2 + (z-zi)^2} - v(tj-ti) = 0$$

$$\sqrt{(x-xk)^2 + (y-yk)^2 + (z-zk)^2} -$$

$$\sqrt{(x-xi)^2 + (y-yi)^2 + (z-zi)^2} - v(tk-ti) = 0$$

...

$$\sqrt{(x-xl)^2+(y-yl)^2+(z-zl)^2} -$$

$$\sqrt{(x-xi)^2+(y-yi)^2+(z-zi)^2} - v(tl-ti) = 0$$

$ti$, $tj$, $tk$, $tl$ représentent les instants de réception de l'onde acoustique émise par la décharge partielle par chacun des détecteurs acoustiques 5.1, 5.2, 5.3, 5.4. Ces instants de réception correspondent aux positions du front d'onde déterminées par le procédé exposé plus haut.

On vérifie ensuite que les coordonnées x, y, z trouvées sont bien situées à l'intérieur de l'enceinte 2 dont on connaît les dimensions. Si ce n'est pas le cas on élimine la position trouvée. Dans le cas où il n'y a que quatre détecteurs, il faudrait les repositionner et recommencer la manoeuvre.

Si on dispose de plus de quatre détecteurs acoustiques, on peut recommencer le même calcul en choisissant au moins un autre quadruplet de détecteurs et ce tant que tous les quadruplets n'ont pas été utilisés. On localisera la source de décharge S partielle en calculant une moyenne de toutes les positions déterminées avec chacun des quadruplets.

Ce procédé de localisation de décharge partielle est connu sous le nom de procédé R. BUCHER qui est un procédé de triangulation conventionnel.

Il est possible d'utiliser un procédé plus sophistiqué de manière à améliorer la précision de la localisation. Ce procédé a été décrit dans la demande de brevet français n° 04 50729 déposée le 13 Avril 2004 au nom de la demanderesse.

On utilise comme dans le cas précédent plusieurs détecteurs acoustiques 5.1 à 5.x. Leur nombre est d'au moins trois dans une variante et d'au moins quatre dans une autre variante. Ils sont placés contre l'extérieur de l'enceinte 2 comme dans le cas précédent. On définit parmi les X détecteurs acoustiques, Y groupes de détecteurs acoustiques avec

```
Y = Z !/3 !(Z-3) !,
```

chaque groupe comportant au moins trois détecteurs et Z étant égal à X ou à X-1.

On réalise une première vérification pour s'assurer que chaque groupe est exempt de triangle, à sommets matérialisés par trois détecteurs acoustiques, dont au moins un angle est hors d'une plage d'angles prédéterminée. Dans le cas contraire on élimine le groupe. La plage d'angles peut être comprise entre 30° et 151° bornes incluses

Pour chaque groupe non éliminé après la première vérification, on calcule une position approchée de la source de décharge partielle S à partir de la position des détecteurs acoustiques du groupe et de l'instant de réception de l'onde acoustique émise par la source de décharge partielle par chacun des détecteurs du groupe. Ces instants de réception sont matérialisés les positions déterminées par le procédé exposé précédemment et sont notés t1 à tx.

On réalise une seconde vérification pour s'assurer que chaque groupe, non éliminé après la première vérification, est exempt de triangle, à sommets matérialisés par deux des détecteurs du groupe et par la position de la source de décharge partielle S vue du groupe, dont moins un angle est hors de la plage prédéterminée. Dans le cas contraire, on élimine le groupe. On calcule la position recherchée de la source de décharge partielle S, en effectuant une moyenne des positions calculées pour tout ou partie des groupes non éliminés après la seconde vérification.

Bien sûr comme dans le procédé décrit précédemment on acquiert les dimensions de l'enceinte 2. On effectue une vérification additionnelle pour s'assurer que la position de la source de décharge partielle S, calculée pour chacun des groupes non éliminés après la seconde vérification, se trouve à l'intérieur de l'enceinte 2 de l'appareil 1, dans le cas contraire élimination du groupe.

Dans le cas où Z = X - 1, le groupe de détecteurs est un quadruplet incluant un détecteur acoustique servant de référence temporelle. Le calcul des positions de la source de décharge vue du groupe se faisant par optimisation en résolvant le même système d'équations que dans le procédé R. Bucher.

$$\sqrt{(x-xj)^2+(y-yj)^2+(z-zj)^2} -$$

$$\sqrt{(x-xi)^2+(y-yi)^2+(z-zi)^2} - v(tj-ti) = 0$$

$$\sqrt{(x-xk)^2+(y-yk)^2+(z-zk)^2} -$$

$$\sqrt{(x-xi)^2+(y-yi)^2+(z-zi)^2} - v(tk-ti) = 0$$

$$\sqrt{(x-xl)^2+(y-yl)^2+(z-zl)^2} -$$

$$\sqrt{(x-xi)^2+(y-yi)^2+(z-zi)^2} - v(tl-ti) = 0$$

dans lequel x, y, z représentent la position de la source de décharge partielle S vue du groupe de détecteurs, (xi, yi, zi), (xj, yj, zj), (xk, yk, zk), (xl, yl, zl) la position des quatre détecteurs acoustiques du quadruplet, ti, tj, tk, tl les instants de réception de l'onde acoustique émise par la décharge partielle par chacun des détecteurs acoustiques du quadruplet, v est la vitesse de l'onde acoustique dans le fluide. Les instants de réception sont matérialisés par les positions déterminées pour chacun des détecteurs par le procédé exposé ci-dessus

Dans le cas où Z=X, le groupe de détecteurs est un triplet. Le calcul de la position vue par le groupe se fait par triangulation en résolvant le système d'équations suivant :

$$(x-xi)^2 + (y-yi)^2 + (z-zi)^2 - v^2(ti-t0)^2 = 0$$

$$(x-xj)^2 + (y-yj)^2 + (z-zj)^2 - v^2(tj-t0)^2 = 0$$

$$(x-xk)^2 + (y-yk)^2 + (z-zk)^2 - v^2(tk-t0)^2 = 0$$

dans lequel x, y, z représentent la position vue par le groupe de détecteurs de la source de décharge partielle S, (xi, yi, zi), (xj, yj, zj), (xk, yk, zk) la position des détecteurs acoustiques du triplet, t0 un instant d'émission d'une décharge partielle générée par la source de décharge partielle 2 et ti, tj, tk les instants de réception de l'onde acoustique émise par la décharge partielle par chacun des détecteurs acoustiques du triplet, v la vitesse de l'onde acoustique dans le fluide. Les instants ti, tj, tk sont matérialisés par les positions déterminées par le procédé de détermination de la position d'un front d'onde exposé précédemment.

L'instant t0 d'émission de la décharge partielle peut être mesuré par des moyens électriques 8 tels un détecteur de type antenne qui coopèrent avec l'enceinte 1. Ces moyens électriques ne sont pas utiles dans les modes de réalisation précédents puisqu'on utilise des quadruplets de détecteurs acoustiques.

Dans ce mode de réalisation, les moyens électriques 8 détectent une onde haute fréquence ou ultra haute fréquence émise par la source de décharge partielle S. Un tel détecteur de type antenne est décrit dans la demande de brevet français FR-A-2 851 852 déposée au nom d'ALSTOM le 27 février 2003. Le détecteur de type antenne 8 est placé dans un logement 10 rapporté sur l'enceinte 1. Ce logement 10 se situe au niveau d'une vanne de vidange généralement prévue en partie basse de l'enceinte 1 pour permettre de retirer le fluide diélectrique ou de faire des tests.

La référence 9 indique des moyens de traitement du signal issu du détecteur de type antenne 8. Les signaux issus du détecteur de type antenne 8, après traitement, sont injectés dans les moyens de calcul 6 puisqu'ils servent tous comme les signaux issus des détecteurs 5.1, 5.2, 5.3, 5.4 au calcul de la position de la source de décharge partielle S.

Bien que plusieurs modes de réalisation de la présente invention aient été représentés et décrits de façon détaillée, on comprendra que différents changements et modifications puissent être apportés sans sortir du cadre de l'invention.

## DOCUMENTS CITES

[1] Nikias C.L. and Mendel J.M., Signal processing with higher-order spectra", IEEE Signal processing Magazine, vol.1, n°3, pp.10-37, July 1993.

[2] Nikias C.L. and Petropuly A., "Higher-Order Spectra Analysis : A Nonlinear Signal Processing Framework", New Jersey : Prentice-Hall, 1993.

[3] Mendel J.M., "Tutorial on higher-order statistics (spectra) in signal processing and system theory : Theoritical results and some applications", Proc. IEEE, vol.79, pp. 278-305, 1991.

[4] Nikias C.L. and Pan R., "Time delay estimation in unknown Gaussian spatially correlated noise", IEEE Trans. Acoust., Speech, Signal Processing, vol. 36, pp. 1706-14, Nov. 1988.

[5] Chiang H.H. and Nikias C.L., "A new method for adaptive time delay estimation for non-gaussian signals", IEEE Trans. Acousti., Signal Processing, vol.38, n°2, Feb. 1990.

[6] Swami A. and Mendel J.M., "Cumulant-based approach to the harmonic retrieval and related problems", IEEE Trans. Acoust., Speech, Signal Processing, vol. 39, pp.1099-1109, May 1991.

[7] Phung, James, Blackburn, Su : "Partial discharge ultrasonic Wave Propagation in Steel Transformer Tanks", 7th International Symposium on High Voltage Engineering, Tecknische Universität Dresden, August 26-30, 1991, pp. 131-134.

## Revendications

**1.** Procédé de détection d'un front d'onde (F) dans un signal reçu par un détecteur, **caractérisé en ce qu'**il consiste à :

- convertir le signal en un signal numérique,
- définir dans le signal numérique un groupe de travail de N échantillons successifs et éventuellement traiter les échantillons du groupe de travail,
- calculer à partir des échantillons du groupe de travail éventuellement traités, l'énergie du signal en terme de moyenne quadratique sur une fenêtre glissante, la fenêtre comportant un nombre optimal d'échantillons (Lopt) (Lopt inférieur à N),
- la position du front d'onde correspondant à celle de l'échantillon pour lequel l'énergie du signal dépasse pour la première fois un seuil (D) qui est fonction de la valeur de l'énergie du signal antérieurement au front d'onde.

**2.** Procédé selon la revendication 1, **caractérisé en ce qu'**il consiste à déterminer le nombre optimal d'échantillons (Lopt) de la fenêtre en :

- choisissant un nombre arbitraire (L') d'échantillons,
- calculant l'énergie du signal partielle en terme de moyenne quadratique dans une plage de P premiers échantillons du groupe de travail, la fenêtre glissante comportant le dit nombre arbitraire (L') d'échantillons,
- calculant la moyenne de l'énergie du signal partielle en terme de moyenne quadratique dans la plage des P premiers échantillons,
- calculant l'écart-type de l'énergie du signal partielle en terme de moyenne quadratique dans la plage des P premiers échantillons,
- calculant le rapport de la moyenne sur l'écart-type, le nombre optimal d'échantillons (Lopt) de la fenêtre glissante correspondant au minimum de ce rapport ou à défaut au maximum de ce rapport.

**3.** Procédé selon l'une des revendications 1 à 2 dans lequel le seuil (D) est un multiple (r) de l'écart-type ($\sigma$) auquel on ajoute la moyenne ($\mu$) dans la plage des P premiers échantillons.

**4.** Procédé selon l'une des revendications 1 à 3, dans lequel la définition du groupe de travail (G) consiste à ôter dans un groupe d'échantillons obtenu par la conversion analogique numérique un sous-groupe (z3) d'échantillons successifs considéré comme saturé.

5. Procédé selon la revendication 4, dans lequel un premier échantillon x(k) du sous-groupe est considéré comme saturé si cet échantillon x(k) et les trois qui le suivent x(k+1), x(k+2), x(k+3) vérifient les relations suivantes :

$$\left| x(k) - x(k+1) \right| > \varepsilon$$

et

$$\left| x(k+1) - x(k+2) \right| > \varepsilon$$

et

$$\left| x(k+2) - x(k+3) \right| > \varepsilon$$

et

$$\left| x(k) \right| > \theta$$

avec $\varepsilon$ premier plancher et $\theta$ second plancher, le sous-groupe comprenant tous les échantillons du groupe d'échantillons obtenu par la conversion analogique, qui suivent le premier échantillon considéré comme saturé.

6. Procédé selon la revendication 5, dans lequel le premier plancher $\varepsilon$ est égal à $10^{-6}$V et le second plancher $\theta$ est égal à 1V.

7. Procédé selon l'une des revendications 1 à 6, dans lequel le traitement consiste à filtrer les échantillons de manière à éliminer d'une part une composante continue et d'autre part à amplifier des échantillons dans les plus hautes fréquences.

8. Procédé selon la revendication 7, dans lequel le filtrage est une dérivation.

9. Procédé selon l'une des revendications 1 à 8, dans lequel le nombre P d'échantillons dans la plage est une fraction (u) de la position (jc) d'un premier échantillon pour lequel l'énergie du signal sous forme de moyenne quadratique est supérieure à un multiple (q) du maximum de l'énergie du signal sous forme de moyenne quadratique sur une plage d'un nombre approché P' de premiers échantillons du signal, q et P' étant choisis arbitrairement.

10. Procédé selon la revendication 9, dans lequel la fraction u est choisie comme étant égale à 0, 9.

11. Procédé de détermination du temps de réponse d'au moins un détecteur exposé à un signal acoustique comportant un front d'onde, **caractérisé en ce qu'**il consiste à détecter le front d'onde du signal reçu par le détecteur selon le procédé de détection d'un front d'onde des revendications 1 à 10 et à comparer la position détectée au niveau du détecteur à celle détectée par le même procédé au niveau d'un autre détecteur dit de référence.

12. Procédé de détection et de localisation d'une source de décharge partielle (S) dans un appareil électrique (1) placé dans une enceinte (2) contenant un fluide acoustiquement conducteur **caractérisé en ce qu'**il consiste :

- à disposer plusieurs détecteurs acoustiques (5.1 à 5.x) contre l'extérieur de l'enceinte et à acquérir leurs positions,
- à former un ou plusieurs groupes de détecteurs ces groupes étant des triplets ou des quadruplets,
- à détecter pour chacun des détecteurs de certains groupes au moins, la position d'un front d'une onde acoustique émise par la source de décharge partielle (S) par le procédé des revendications 1 à 10, cette position étant représentative de l'instant de réception de l'onde acoustique émise par la source de décharge partielle (S) par chacun des détecteurs ;

à calculer, pour certains groupes au moins, la position de la source de décharge partielle (S) vue de ces groupes à partir de la position des détecteurs acoustiques et de l'instant de réception de l'onde acoustique émise par la source de décharge partielle par chacun des détecteurs.

**13.** Procédé selon la revendication 12, dans lequel le calcul de la position de la source de décharge partielle vue d'un groupe formé d'un triplet se fait par optimisation en résolvant le système d'équations suivants :

$$(x-xi)^2 + (y-yi)^2 + (z-zi)^2 - v^2(ti-t0)^2 = 0$$

$$(x-xj)^2 + (y-yj)^2 + (z-zj)^2 - v^2(tj-t0)^2 = 0$$

$$(x-xk)^2 + (y-yk)^2 + (z-zk)^2 - v^2(tk-t0)^2 = 0$$

dans lequel x, y, z représentent la position de la source de décharge partielle, (xi, yi, zi), (xj, yj, zj), (xk, yk, zk) la position des détecteurs acoustiques du triplet, t0 un instant d'émission d'une décharge partielle générée par la source de décharge partielle et ti, tj, tk les instants de réception de l'onde acoustique émise par la décharge partielle par chacun des détecteurs acoustiques du triplet, v la vitesse de l'onde acoustique dans le fluide.

**14.** Procédé selon la revendication 13, dans lequel l'instant t0 d'émission de la décharge partielle est mesuré par des moyens électriques (8) tels un détecteur électrique de type antenne qui coopère avec l'enceinte (2) .

**15.** Procédé selon la revendication 12, dans lequel le calcul de la position de la source de décharge partielle vue d'un groupe formé d'un quadruplet se fait par triangulation en résolvant le système d'équations suivant :

$$\sqrt{(x-xj)^2+(y-yj)^2+(z-zj)^2} - \sqrt{(x-xi)^2+(y-yi)^2+(z-zi)^2} - v(tj-ti) = 0$$

$$\sqrt{(x-xk)^2+(y-yk)^2+(z-zk)^2} - \sqrt{(x-xi)^2+(y-yi)^2+(z-zi)^2} - v(tk-ti) = 0$$

$$\sqrt{(x-xl)^2+(y-yl)^2+(z-zl)^2} - \sqrt{(x-xi)^2+(y-yi)^2+(z-zi)^2} - v(tl-ti) = 0$$

dans lequel x, y, z représentent la position de la source de décharge partielle S, (xi, yi, zi), (xj, yj, zj), (xk, yk, zk), (xl, yl, zl) la position des quatre détecteurs acoustiques du quadruplet, ti, tj, tk, tl les instants de réception de l'onde acoustique émise par la décharge partielle par chacun des détecteurs acoustiques du quadruplet, v est la vitesse de l'onde acoustique dans le fluide.

**16.** Procédé selon l'une des revendications 12 à 15, dans lequel on vérifie que la position de la source de décharge partielle vue d'un groupe se trouve à l'intérieur de l'enceinte, sinon on élimine ladite position.

**17.** Procédé selon la revendication 12, dans lequel on effectue une première vérification avant le calcul pour s'assurer que chaque groupe est exempt de triangle, à sommets matérialisés par trois détecteurs acoustiques, dont au moins un angle est hors d'une plage d'angle prédéterminée, dans le cas contraire le groupe ne participe pas au calcul.

**18.** Procédé selon la revendication 17, dans lequel on effectue une seconde vérification après le calcul pour s'assurer que chaque groupe non éliminé après la première vérification est exempt de triangle matérialisé par deux des détecteurs du groupe et par la position vue du groupe de la source de décharge partielle, dont au moins un angle est hors de la plage prédéterminée, dans le cas contraire le groupe est éliminé.

**19.** Procédé selon la revendication 17 ou 18, dans lequel la plage d'angles s'étend entre 30° et 151° bornes incluses.

**20.** Procédé selon la revendication 12, dans lequel lorsqu'on obtient plusieurs positions vues de plusieurs groupes non éliminés et que ces positions se trouvent à l'intérieur de l'enceinte, on calcule une moyenne des positions de la source de décharge partielle calculées pour chacun des groupes et non éliminées.

FIG. 1A

FIG. 1B

FIG. 1C

FIG. 2A

FIG. 2B

FIG. 2C

FIG. 3

FIG. 4A

FIG. 4B

FIG. 5A

FIG. 5B

FIG. 6A

FIG. 6B

FIG. 6C

FIG. 6D

FIG. 7

FIG. 8A

FIG. 8B

FIG. 8C

FIG. 8D

## FIG. 8E

## FIG. 8F

| Détecteur | Position front d'onde | |
|---|---|---|
| | Visuelle | Procédé |
| Ch 2 | -69,8 µs | -55,6 µs |
| Ch 3 | -80,1 µs | -94,8 µs |
| Ch 4 | 251,0 µs | 210 µs |
| Ch 5 | 225,0 µs | 228,0 µs |
| Ch 6 | 240,0 µs | 218,0 µs |

FIG. 9

**Office européen
des brevets**

**RAPPORT DE RECHERCHE EUROPEENNE**

Numéro de la demande

EP 06 11 1743

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 3 887 871 A (AECHTER ET AL) 3 juin 1975 (1975-06-03) * le document en entier * | 1 | INV. G01R31/12 |
| A | US 4 414 850 A (MIWA ET AL) 15 novembre 1983 (1983-11-15) * colonne 2, ligne 17 - ligne 23; figure 3 * | 1 | |
| A | US 2004/246000 A1 (KUPPUSWAMY RAJA) 9 décembre 2004 (2004-12-09) * revendications 1,8,12 * | 1,11,12 | |
| A | US 6 137 438 A (MCEWAN ET AL) 24 octobre 2000 (2000-10-24) * abrégé; figures 2b,5,6b,7,8 * | 1 | |
| A | US 6 314 055 B1 (FOXLIN ERIC ET AL) 6 novembre 2001 (2001-11-06) * abrégé; figures 1,4 * | 1 | |
| A | US 6 708 023 B1 (PINCENTI JOHN C ET AL) 16 mars 2004 (2004-03-16) * revendications 3,4 * | 1 | DOMAINES TECHNIQUES RECHERCHES (IPC) G01R G01S G01F H03K |

Le présent rapport a été établi pour toutes les revendications

| Lieu de la recherche | Date d'achèvement de la recherche | Examinateur |
|---|---|---|
| La Haye | 26 juin 2006 | Koll, H |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...............................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 06 11 1743

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

26-06-2006

| Document brevet cité au rapport de recherche | | Date de publication | Membre(s) de la famille de brevet(s) | | Date de publication |
|---|---|---|---|---|---|
| US 3887871 | A | 03-06-1975 | DE | 2254019 A1 | 16-05-1974 |
| | | | FR | 2205997 A5 | 31-05-1974 |
| | | | GB | 1433766 A | 28-04-1976 |
| | | | JP | 49079283 A | 31-07-1974 |
| | | | NO | 140805 B | 06-08-1979 |
| US 4414850 | A | 15-11-1983 | DE | 3167578 D1 | 17-01-1985 |
| | | | EP | 0041403 A1 | 09-12-1981 |
| | | | JP | 57000550 A | 05-01-1982 |
| US 2004246000 | A1 | 09-12-2004 | BR | 0401902 A | 22-02-2005 |
| | | | CA | 2469443 A1 | 05-12-2004 |
| | | | EP | 1484616 A1 | 08-12-2004 |
| | | | FR | 2855878 A1 | 10-12-2004 |
| US 6137438 | A | 24-10-2000 | AU | 1307900 A | 14-02-2000 |
| | | | WO | 0005597 A2 | 03-02-2000 |
| US 6314055 | B1 | 06-11-2001 | AU | 1313300 A | 08-05-2000 |
| | | | WO | 0023815 A1 | 27-04-2000 |
| US 6708023 | B1 | 16-03-2004 | AUCUN | | |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 0450729
- FR 2851852 A, ALSTOM

**Littérature non-brevet citée dans la description**

- **NIKIAS C.L ; MENDEL J.M.** Signal processing with higher-order spectra. *IEEE Signal processing Magazine,* Juillet 1993, vol. 1 (3), 10-37
- **NIKIAS C.L. ; PETROPULY A.** Higher-Order Spectra Analysis : A Nonlinear Signal Processing Framework. Prentice-Hall, 1993
- **MENDEL J.M.** Tutorial on higher-order statistics (spectra) in signal processing and system theory : Theoritical results and some applications. *Proc. IEEE,* 1991, vol. 79, 278-305
- **NIKIAS C.L. ; PAN R.** Time delay estimation in unknown Gaussian spatially correlated noise. *IEEE Trans. Acoust., Speech, Signal Processing,* Novembre 1988, vol. 36, 1706-14
- **CHIANG H.H. ; NIKIAS C.L.** A new method for adaptive time delay estimation for non-gaussian signals. *IEEE Trans. Acousti., Signal Processing,* Février 1990, vol. 38 (2
- **SWAMI A. ; MENDEL J.M.** Cumulant-based approach to the harmonic retrieval and related problems. *IEEE Trans. Acoust., Speech, Signal Processing,* Mai 1991, vol. 39, 1099-1109
- Partial discharge ultrasonic Wave Propagation in Steel Transformer Tanks. **PHUNG, JAMES ; BLACKBURN, SU.** 7th International Symposium on High Voltage Engineering. Tecknische Universität Dresden, 26 Août 1991, 131-134